(19) Europäisches Patentamt
European Patent Office
Office européen des brevets

(11) **EP 4 024 057 B1**

(12) **EUROPEAN PATENT SPECIFICATION**

(45) Date of publication and mention
of the grant of the patent:
**23.08.2023 Bulletin 2023/34**

(21) Application number: **20875191.7**

(22) Date of filing: **30.09.2020**

(51) International Patent Classification (IPC):
**G01R 19/25** *(2006.01)* **G01R 15/18** *(2006.01)*
**G01R 31/00** *(2006.01)* **G01R 31/52** *(2020.01)*

(52) Cooperative Patent Classification (CPC):
**G01R 15/183; G01R 31/52**

(86) International application number:
**PCT/CN2020/119323**

(87) International publication number:
**WO 2021/068832 (15.04.2021 Gazette 2021/15)**

(54) **RESIDUAL CURRENT DETECTION METHOD BASED ON MAGNETIC CORE WORKING STATE SWITCHING**

FEHLERSTROMDETEKTIONSVERFAHREN BASIEREND AUF MAGNETISCHER KERNARBEITSZUSTANDSSCHALTUNG

PROCÉDÉ DE DÉTECTION DE COURANT RÉSIDUEL BASÉ SUR UNE COMMUTATION D'ÉTAT DE TRAVAIL DE NOYAU MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.10.2019 CN 201910955505**

(43) Date of publication of application:
**06.07.2022 Bulletin 2022/27**

(73) Proprietor: **Qingdao Topscomm Communication Co., Ltd**
**Qingdao, Shandong 266000 (CN)**

(72) Inventors:
• **JIANG, Zean**
  **Qingdao, Shandong 266000 (CN)**
• **WANG, Jianhua**
  **Qingdao, Shandong 266000 (CN)**
• **LIU, Zhen**
  **Qingdao, Shandong 266000 (CN)**

(74) Representative: **Kolster Oy Ab**
**Salmisaarenaukio 1**
**P.O. Box 204**
**00181 Helsinki (FI)**

(56) References cited:
EP-A1- 3 121 609      CN-A- 101 923 134
CN-A- 103 675 396     CN-A- 107 979 066
CN-A- 110 609 171     CN-A- 110 672 913
CN-U- 202 770 898     CN-U- 204 116 431
JP-A- 2012 233 718

**Description**

**FIELD**

The present disclosure belongs to the field of leakage detection, and mainly relates to a method for detecting a residual current based on switching of working states of a magnetic core.

**BACKGROUND**

With the development of economy, the power industry develops rapidly, types of various household appliances are increasing rich. Therefore, how to ensure electricity safety of household becomes particularly important. It is desirable to detect a variety of complex wave signals, including an alternating current, a direct current, a high-frequency signal, or the like. An alternating current residual current is extremely dangerous to the person, ventricular tremor may be caused at 50mA/s. With the increase in the type of household appliances, it is also important to detect a direct current residual current. At present, the direct current is widely used, including direct current charging pile, variable frequency motor, etc., household appliance, such as certain types of notebook, microwave oven, washing machine.

The document EP 3 121 609 A1 discloses the detection of DC residual currents using a magnetic core which is excited by a square wave signal applied to a winding around the core.

Therefore, there is an urgent need for high-precision detection of the alternating current residual current, the direct current residual current and a complex waveform.

Currently, there are products for residual current detection of type B and higher specification on the market, and electromagnetic current transformer, Hall current sensor and magnetic modulation current transformer, etc. are mostly used for residual current detection in which there are disadvantages, such as low detection precision and inability to cover all residual current waveforms. Therefore, it is desirable to develop a method that can effectively solve the above two problems.

**SUMMARY**

In the present disclosure, for the above problems and in order to overcome the disadvantages of the conventional technology, a method for detecting a residual current based on switching of working states of a magnetic core is provided, in which the magnetic core is made of ferrite, and by the means of combining a voltage excitation mode with a pure induction mode, data is processed in a full electronic manner, which effectively solves the two problems, that is, all types of residual current are covered and a high-precision determination is achieved.

The present disclosure relates to a technology of detecting a complex residual current by using different responses of the magnetic core to the alternating current residual current and the direct current residual current in different regions of a magnetization curve and switching the working state. A leakage test is performed by detecting the residual current in the line, and the values of different types of residual currents are calculated through secondary algorithm analysis and the residual currents are determined by software, so as to achieve the protection against leakage.

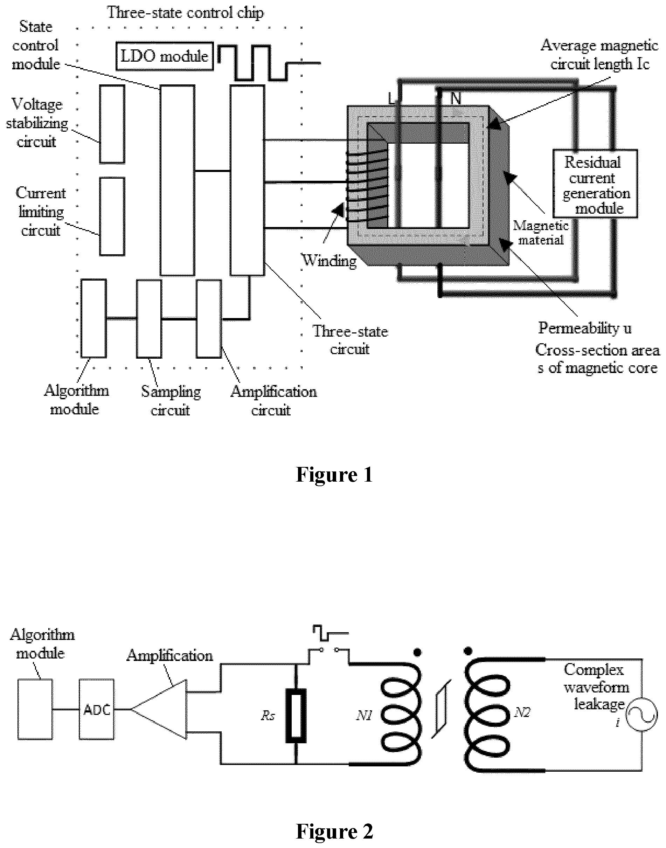

In the present disclosure, a residual current transformer of two-phase coil is used as a detection device. As shown in Figure 1, the working state of a detection winding is controlled by a chip, so as to detect different types of residual current. The alternating current residual current is an alternating signal, so a sensing signal may be generated through the coil. At this time, an undistorted alternating current signal can be sensed by using a linear region of the magnetic core. The measuring range of the detectable signal in the linear region meets the requirements of the national standard, which has be verified by calculation, and the signal exceeding the range may be directly determined as an over threshold signal; the direct current residual current is considered to be constant current when it exists, so a constant magnetic field is generated. At this time, the coil cannot be used for directly sensing the direct current magnetic field, but the direct current may correspond to a sensing signal in a nonlinear region of the hysteresis loop. Therefore, in the case of measuring the direct current, the signal acts on two saturation regions of the hysteresis loop alternately by using the positive and negative excitation square wave, different direct current may generate different responses in different regions, and the direct current detection can be completed by means of algorithm analysis and processing.

By using the linear region of the hysteresis loop of ferrite, when there is an alternating signal, the corresponding signal may be sensed by a secondary side, and the amplitude is inversely proportional to the number of coil turns. Since the linear region of ferrite is relatively wide, it has better characteristics of measuring the alternating current residual current. For 50Hz power frequency signal, due to the low frequency, the amplitude of the sensing signal may become smaller, but the difference can be compensated by software compensation. Other high-frequency signals can be sensed in the linear region, and the effect of sensing is only related to the material characteristics, and the ferrite parameters can be customized to meet the performance requirements of high-frequency alternating current detection.

Using the characteristics of the hysteresis loop of ferrite, the direct current signal is not sensitive to the linear region, and the same principle is used in the saturation region, but there is a sensing value for direct current in the nonlinear region. The detection of the direct current residual current can be completed by the means of value change in the nonlinear region. A saturation excitation square wave has to be a bipolar square wave, and the chip can only output a unipolar square wave. In order to realize the bipolar square wave excitation to the magnetic core and ensure that the magnetic core can enter the saturation region bidirectionally, the unipolar square wave may be converted into the bipolar square wave through an H-bridge. When the magnetic core enters saturation at half wave, a reverse square wave excitation is applied immediately, that is, the reverse magnetic field of the same size is generated, and at this time, the winding changes from a magnetic saturation region on one side to a magnetic saturation region on the other side. Different direct current leakage values make the time to reach the number of ampere turns of saturation different and the corresponding currents different. The difference of different direct current residual currents can be extracted from the sampling of the sampling resistor, and the corresponding direct current leakage value is obtained by means of algorithm analysis.

**BRIEF DESCRIPTION OF THE DRAWINGS**

Figure 1 is a schematic diagram of the working principle of a residual current transformer;

Figure 2 is a schematic diagram of a simplified model of the detection device;

Figure 3 is a schematic diagram of three-state switching working in different regions of the hysteresis loop;

Figure 4 is a schematic diagram of a simplified model of the hysteresis loop of ferrite;

Figure 5 is a diagram showing the effect of direct current leakage using excitation square wave;

Figure 6 is a diagram showing direct current residual current data;

Figure 7 is a diagram showing alternating current residual current data.

**DETAILED DESCRIPTION**

The technology of performing complex residual current detection by using the three-state switching of different magnetic core working states proposed in the present disclosure is described below in combination with Figures 1 to 7, so as to set forth the technical solution of the present disclosure in detail.

In the present disclosure, a ferrite residual current transformer is used as the detection device to complete the detection of a complex residual current through three-state switching control. As shown in Figure 2, in case of detecting an alternating current, a state control module controls a circuit to work in a pure induction mode with no voltage. A current signal of an alternating residual current may be sensed by a coil by using the characteristics of a linear region of a magnetic core, and the current signal is collected through a sampling resistor.

In case of detecting an alternating current, the magnetic core works in the linear region. According to the ampere circuital theorem, the magnetic field strength H is:

$$H = \frac{N_1 \cdot I_{ac} + N_2 \cdot I_{dc}}{l}$$

when the magnetic core works in the linear region, the permeability u is almost constant, the magnetic induction intensity B is:

$$B = \mu_l \cdot H = \mu_l \cdot \frac{N_1 \cdot I_{ac} + N_2 \cdot I_{dc}}{l}$$

and the induced electromotive force E is:

$$E = \frac{d\phi}{dt} = \frac{dB \cdot S}{dt} = \frac{d\left(\mu_l \cdot \dfrac{N_1 \cdot I_{ac} + N_2 \cdot I_{dc}}{l}\right)}{dt} = \frac{\mu_l \cdot N_1}{l} \cdot \frac{dI_{ac}}{dt}$$

From the above formulas, it may be inferred that when the magnetic core works in the linear region, the signal is sensitive to an alternating current signal and not sensitive to a direct current signal, so it is considered that the sensing signal is an alternating current signal.

When the signal passes through a nonlinear region, the permeability is changing, and when the excitation amplitude changes with time, the permeability may be regarded as a time-varying parameter $\mu$ (t). At this time, the sensing signal of the coil may be expressed as:

$$E = \frac{d\phi}{dt} = \frac{dB \cdot S}{dt}$$

$$= \frac{d\left(\mu(t) \cdot \dfrac{N_1 \cdot I_{ac} + N_2 \cdot I_{dc}}{l}\right)}{dt}$$

$$= \frac{\mu(t) \cdot N_1}{l} \cdot \frac{dI_{ac}}{dt} + \frac{N_1 \cdot I_{ac}}{l} \cdot \frac{d\mu(t)}{dt} + \frac{N_2 \cdot I_{dc}}{l} \cdot \frac{d\mu(t)}{dt}$$

From the above formula, it may be analyzed that since the permeability $\mu$ (t) is changing when the magnetic core works in the nonlinear region, in the nonlinear region, a signal can be sensed from the direct current. Using the change in the nonlinear region, the direct current signal can be detected and determined by means of algorithm extraction and analysis.

When the excitation signal makes the magnetic core work in the saturation region, the excitation signal enters the deep saturation. At this time, the signal can completely reflect all the characteristics of the hysteresis loop. When the signal enters a deep saturation region, there is no sensing signal since the permeability is approximately equal to 0, but due to the existence of the excitation square wave, the inductor in the circuit has no impeding effect at this time, which is equivalent to a small resistance voltage divider. Therefore, the signal collected by the sampling resistor has a constant voltage value approximate to the amplitude of the excitation square wave.

If the alternating current residual current is large enough and the pure induction mode is used to make the magnetic core work into the saturation region, the alternating current signal may cover all regions of the hysteresis loop, and the sensing waveforms of signals in different regions may have different responses. In the linear region, the alternating current signal may be still sensed. In the nonlinear region, the signal may be superimposed with even harmonics, and in the deep saturation region, there is no sensing signal, and the signal may decay.

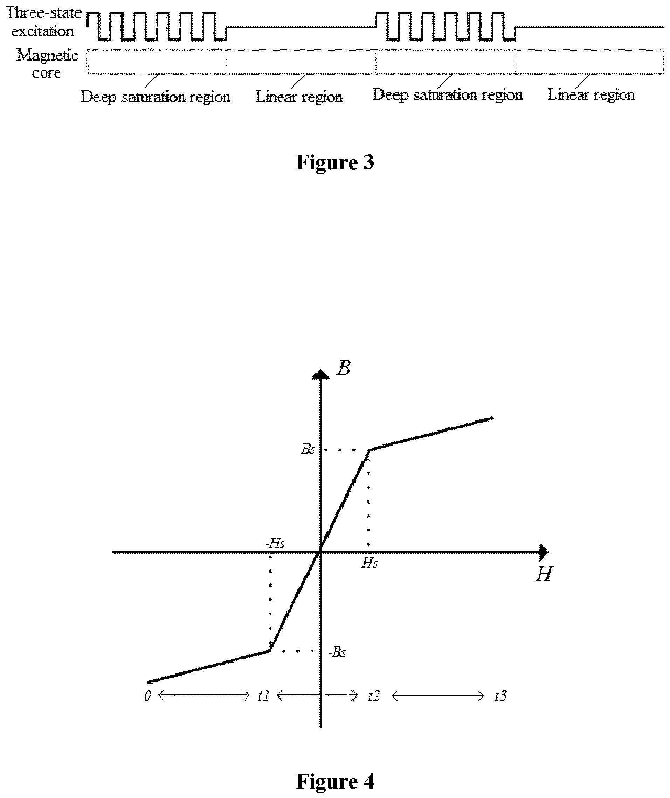

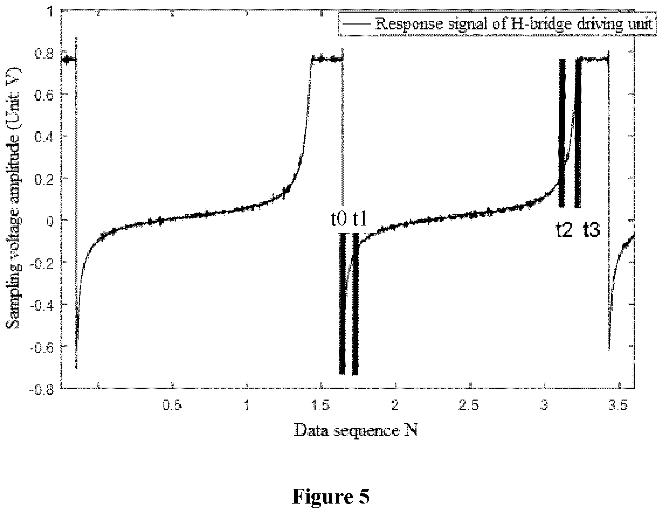

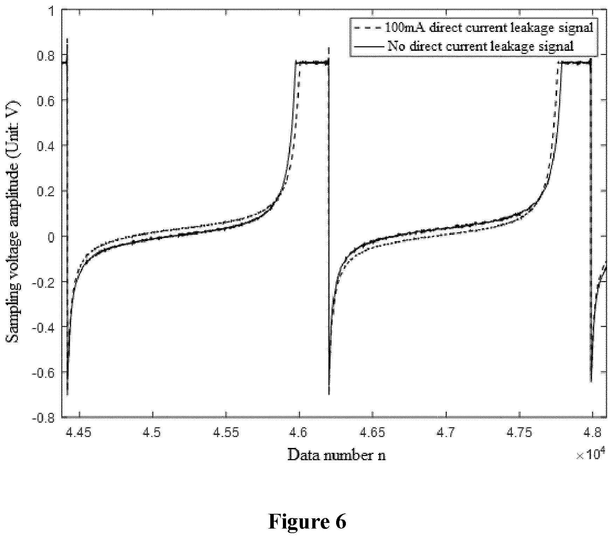

In case of detecting a direct current, positive and negative saturation excitation signals are output by the state control module, and the frequency of the square wave signal is adjustable. The charging time required to reach saturation is calculated according to the number of ampere turns of saturation. The period of the square wave signal is controlled to be greater than or equal to the sum of the bidirectional charging time, and the signal can reach the bidirectional deep saturation region of the magnetic core within the period. As shown in the simplified model of the magnetization curve in Figure 4, in the time period of 0~t1, the permeability is small, the coil has small impeding effect, and the response of the excitation signal changes quickly; in the time period of t1~t2, the permeability is considered to be the largest, and there may be a process that the impeding changes; in the time period of t2~t3, since the permeability changes from large to small, the inductive reactance returns to a small value, the impeding effect becomes small, and the response signal changes rapidly; after t3, the coil enters the deep saturation region and the signal collected by the resistor tends to be stable. As shown in Figure 5, when there is direct current residual current, a waveform with up and down waveform being lateral stability appears. The actual sampling data of the circuit is shown in Figure 6.

Using two states of excitation square wave, not only the direct current residual current may be detected, but also the alternating current residual current of partial frequency may be processed by algorithm analysis. Due to the high frequency of the injected square wave, even for alternating current signal, it can also be considered that the leakage current remains unchanged in one excitation half wave time, and according to the different responses generated by the hysteresis loop to different direct current, different leakage signal values are superimposed on the excitation square wave of a detection winding. The induction principle is the same as the direct current residual current detection principle.

The signal is collected by the sampling resistor, the reproduction of the complex waveform may be completed through feature extraction, and the excitation square wave is a modulated signal relative to the signal to be detected. According to the sampling theorem, it that can be analyzed that the maximum frequency of the sensing signal is 1/5 of the excitation square wave frequency.

The induction current of the detection winding first passes through a PGA amplification circuit through the sampling resistor, then read by an ADC sampling module and inputted into an algorithm DSP unit for analysis.

Step 1: an internal circuit of the chip is controlled to make the coil and the resistor form a pure sensing measurement alternating current mode, at this time, the excitation voltage is 0, the duration is set to t2ms, the coil and the resistor are approximately directly connected. After passing through an operational amplifier circuit, the data is sampled by the ADC, and the sampled data is sent to a hardware algorithm DSP module for calculation and analysis through an algorithm, and then determined.

Step 2: the internal circuit of the chip is controlled, when the alternating current residual current detection is completed, to switch the working state and output the two states of positive and negative voltage, which are generated alternately and are approximately the positive and negative polarity of square wave excitation signals. At this time, the coil and the sampling resistor are superimposed with the excitation square wave, which makes the magnetic core work back and forth in the positive and negative saturation regions for t1ms of excitation duration. After passing through the operational amplifier circuit, the data is sampled by the ADC and the sampled data is sent to the hardware algorithm DSP module for calculation and analysis through the algorithm, and then determined.

Step 3: in the algorithm DSP module, there is a special switching control algorithm to prevent the detection time from being unable to meet the action requirements of the national standard due to the sudden large current. When the complex residual current detection is carried out in a certain state, if the sudden large current is found, an algorithm control module generates an interruption, and according to the specific sampled signal at this time, the type of sudden signal (large direct current, large alternating current, etc.) is analyzed. Combined with the detection state of working in alternating current/direct current at this time, the detection state is controlled to maintain t2/t1ms, or to immediately switch to the direct current/alternating current detection state, and the state is controlled to maintain t2/t1ms. After passing through the operational amplifier circuit, the data is sampled by the ADC and the sampled data is sent to the hardware algorithm DSP module for calculation and analysis through the algorithm, and then determined.

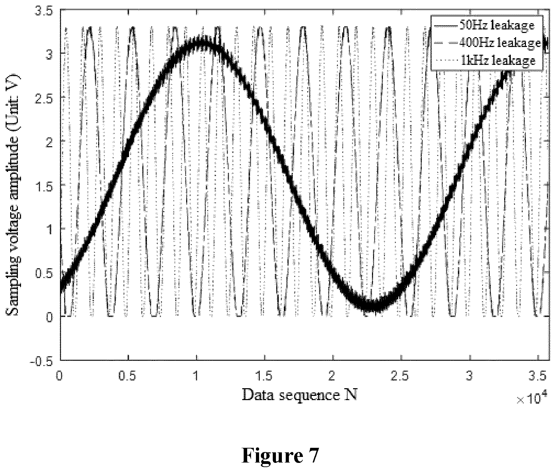

Figures 6 and 7 correspond to the actual sampling signals of the direct current residual current and the alternating current residual current, respectively. The final results can be obtained by means of algorithm feature extraction and analysis. It can be seen from the data in the figures that the actual effect is the same as the theoretical derivation.

The description above is only the preferred embodiment of the disclosure. For those skilled in the art, several improvements and changes can be made without departing from the principle of the present disclosure. Any modification, improvement, etc. made within the scope the present disclosure as defined by the claims shall be included in the protection of the present disclosure.

**Claims**

1.  A method for detecting a residual current based on switching of working states of a magnetic core, the method comprising:

    step 1: configuring, by a control chip, a detection state to be a pure induction mode with no voltage, keeping the pure induction mode for t1ms;
    step 2: configuring, by the control chip, the detection state to be a mode of positive and negative saturation excitation square waves, keeping the mode of positive and negative saturation excitation square waves for t2ms;
    step 3: when a duration of each mode ends, outputting a characteristic quantity based on sampling data through an algorithm module, and processing the characteristic quantity by a software to complete a state determination for a current time instant; and
    step 4: in case of a sudden large current, using a state control module, adjusting the detection state to or maintaining it in a mode corresponding to the sudden large current; and the software performing processing after data collection is completed and processing performed by the algorithm module is completed.

2.  The method for detecting a residual current based on switching of working states of a magnetic core according to claim 1, wherein

    voltages with two states of saturation excitation in positive and negative directions are generated by using an H-bridge driving circuit, and a switching frequency is adjustable; a circuit is adjusted to the pure induction mode, and a sampling resistor and a coil are directly connected; an alternating current residual current and a direct current residual current are detected by switching among three states of positive voltage, negative voltage and no voltage.

3. The method for detecting a residual current based on switching of working states of a magnetic core according to claim 1, wherein
the magnetic core for detecting the residual current is permalloy or amorphous soft magnetic material with high permeability, low remanence and low coercivity.

4. The method for detecting a residual current based on switching of working states of a magnetic core according to claim 1, wherein step 2 comprises:
generating positive and negative saturation excitation voltages by using a H-bridge driving circuit and adjusting a switching frequency, to make a signal enter a saturation region of a hysteresis loop bidirectionally, wherein a direct current residual current generates different sensing signals in different regions of the hysteresis loop, different direct current residual currents are detected by using differences in the different sensing signals, and an actual direct current residual current is obtained by means of algorithm extraction, and an operation for the actual direct current residual current is performed.

5. The method for detecting a residual current based on switching of working states of a magnetic core according to claim 1, wherein
generating a group of excitation response signals by using a positive voltage and a negative voltage, performing data processing by collecting positive and negative response signals in one excitation period, and combining multiple excitation periods to determine the residual current.

6. The method for detecting a residual current based on switching of working states of a magnetic core according to claim 1, wherein
controlling, by the chip, the switching among three modes of the detection state, to detect a full waveform residual current, calculating a value of a signal corresponding to the full waveform residual current by means of algorithm processing, and processing the signal and performing an operation based on the processed signal.

7. The method for detecting a residual current based on switching of working states of a magnetic core according to claim 1, wherein step 4 includes:
responding to residual currents of different waveforms with a large amplitude in case of a sudden signal, identifying the sudden signal by the algorithm module, and switching the detection state by the state control module to collect and process the signal.

**Patentansprüche**

1. Verfahren zum Detektieren eines Reststroms auf Basis des Umschaltens von Arbeitszuständen eines Magnetkerns, wobei das Verfahren Folgendes umfasst:

Schritt 1: Auslegen eines Detektionszustands durch einen Steuerchip derart, dass es sich um einen reinen Induktionsmodus ohne Spannung handelt, Halten des reinen Induktionsmodus für t1 ms;
Schritt 2: Auslegen des Detektionszustands durch den Steuerchip derart, dass es sich um Rechteckwellen mit positiver und negativer Sättigungserregung handelt, Halten des Modus der Rechteckwellen mit positiver und negativer Sättigungserregung für t2 ms;
Schritt 3: wenn eine Dauer jedes Modus endet, Ausgeben einer charakteristischen Menge auf Basis von Abtastdaten über ein Algorithmusmodul und Verarbeiten der charakteristischen Menge durch eine Software, um eine Zustandsbestimmung für eine aktuelle Zeitinstanz abzuschließen; und
Schritt 4: im Fall eines plötzlichen großen Stroms Verwenden eines Zustandssteuermoduls, Anpassen des Detektionszustands an einen Modus, der dem plötzlichen großen Strom entspricht, oder Beibehalten desselben in diesem und
Durchführen einer Verarbeitung durch die Software, nachdem eine Datensammlung abgeschlossen ist und die vom Algorithmusmodul durchgeführte Verarbeitung abgeschlossen ist.

2. Verfahren zum Detektieren eines Reststroms auf Basis des Umschaltens von Arbeitszuständen eines Magnetkerns nach Anspruch 1, wobei
Spannungen mit zwei Zuständen der Sättigungserregung in positiver und negativer Richtung unter Verwendung einer H-Brückenansteuerschaltung erzeugt werden und eine Schaltfrequenz anpassbar ist; eine Schaltung an den reinen Induktionsmodus angepasst wird und ein Abtastwiderstand und eine Spule direkt verbunden sind; ein Restwechselstrom und ein Restgleichstrom durch Umschalten zwischen drei Zuständen einer positiven Spannung, einer negativen Spannung und keiner Spannung detektiert werden.

**3.** Verfahren zum Detektieren eines Reststroms auf Basis des Umschaltens von Arbeitszuständen eines Magnetkerns nach Anspruch 1, wobei

der Magnetkern zum Detektieren des Reststroms Permalloy oder ein amorphes weiches magnetisches Material mit hoher Permeabilität, niedriger Remanenz und niedriger Koerzivität ist.

**4.** Verfahren zum Detektieren eines Reststroms auf Basis des Umschaltens von Arbeitszuständen eines Magnetkerns nach Anspruch 1, wobei Schritt 2 Folgendes umfasst:

Erzeugen von positiven und negativen Sättigungserregungsspannungen unter Verwendung einer H-Brückenansteuerschaltung und Anpassen einer Schaltfrequenz, um zu bewirken, dass ein Signal bidirektional in eine Sättigungsregion einer Hystereseschleife eintritt, wobei ein Restgleichstrom verschiedene Erfassungssignale in verschiedenen Regionen der Hystereseschleife erzeugt, verschiedene Restgleichströme unter Verwendung von Unterschieden bei den verschiedenen Erfassungssignalen detektiert werden und ein tatsächlicher Restgleichstrom mittels einer Algorithmusextrahierung erhalten und eine Operation für den tatsächlichen Restgleichstrom durchgeführt wird.

**5.** Verfahren zum Detektieren eines Reststroms auf Basis des Umschaltens von Arbeitszuständen eines Magnetkerns nach Anspruch 1, wobei

Erzeugen einer Gruppe von Erregungsantwortsignalen unter Verwendung einer positiven Spannung und einer negativen Spannung, Durchführen einer Datenverarbeitung durch Sammeln von positiven und negativen Antwortsignalen in einer Erregungsperiode und Kombinieren von mehreren Erregungsperioden, um den Reststrom zu bestimmen.

**6.** Verfahren zum Detektieren eines Reststroms auf Basis des Umschaltens von Arbeitszuständen eines Magnetkerns nach Anspruch 1, wobei

Steuern des Umschaltens zwischen drei Modi des Detektionszustands durch den Chip, um einen Reststrom mit voller Wellenform zu detektieren, Berechnen eines Wertes eines Signals, das dem Reststrom mit voller Wellenform entspricht, mittels einer Algorithmusverarbeitung und Verarbeiten des Signals und Durchführen einer Operation auf Basis des verarbeiteten Signals.

**7.** Verfahren zum Detektieren eines Reststroms auf Basis des Umschaltens von Arbeitszuständen eines Magnetkerns nach Anspruch 1, wobei Schritt 4 Folgendes beinhaltet:

Antworten auf Restströme unterschiedlicher Wellenformen mit einer großen Amplitude im Fall eines plötzlichen Signals, Identifizieren des plötzlichen Signals durch das Algorithmusmodul und Umschalten des Detektionszustands durch das Zustandssteuermodul, um das Signal zu sammeln und zu verarbeiten.

**Revendications**

**1.** Procédé de détection d'un courant résiduel sur la base d'une commutation d'états de fonctionnement d'un noyau magnétique, le procédé comprenant :

étape 1 : configurer, par une puce de commande, un état de détection comme étant un mode d'induction pure sans tension, en conservant le mode d'induction pure pendant t1 ms ;
étape 2 : configurer, par la puce de commande, l'état de détection comme étant un mode d'ondes carrées d'excitation à saturation positive et négative, en conservant le mode d'ondes carrées d'excitation à saturation positive et négative pendant t2 ms ;
étape 3 : à la fin de la durée de chaque mode, délivrer une quantité caractéristique sur la base des données d'échantillonnage à travers un module algorithmique, et traiter la quantité caractéristique par un logiciel pour accomplir une détermination d'état pour un instant présent ; et
étape 4 : en cas d'un courant soudain et important, à l'aide d'un module de commande d'état, régler l'état de détection ou le maintenir dans un mode correspondant au courant soudain et important ; et le logiciel effectue un traitement après qu'une collecte de données a été accomplie et qu'un traitement effectué par le module algorithmique a été accompli.

**2.** Procédé de détection d'un courant résiduel sur la base d'une commutation d'états de fonctionnement d'un noyau magnétique selon la revendication 1, dans lequel

des tensions avec deux états d'excitation de saturation dans des directions positive et négative sont générées en utilisant un circuit d'attaque en pont en H, et une fréquence de commutation est réglable ; un circuit est réglé sur le mode d'induction pure, et une résistance d'échantillonnage et une bobine sont directement connectées ; un courant résiduel de courant alternatif et un courant résiduel de courant continu sont détectés par la commutation entre trois états de tension positive, de tension négative et d'absence de tension.

3. Procédé de détection d'un courant résiduel sur la base d'une commutation d'états de fonctionnement d'un noyau magnétique selon la revendication 1, dans lequel
le noyau magnétique de détection du courant résiduel est un permalloy ou un matériau magnétique doux amorphe avec une perméabilité élevée, une faible rémanence et une faible coercivité.

4. Procédé de détection d'un courant résiduel sur la base d'une commutation d'états de fonctionnement d'un noyau magnétique selon la revendication 1, dans lequel l'étape 2 comprend :
la génération de tensions d'excitation à saturation positive et négative en utilisant un circuit d'attaque en pont en H et en réglant une fréquence de commutation, pour faire entrer un signal dans une région de saturation d'une boucle d'hystérésis de manière bidirectionnelle, dans lequel un courant résiduel continu génère différents signaux de détection dans différentes régions de la boucle d'hystérésis, différents courants résiduels de courant continu sont détectés en utilisant les différences dans les différents signaux de détection, et un courant résiduel continu réel est obtenu au moyen d'une extraction d'algorithme, et une opération pour le courant résiduel continu réel est réalisée.

5. Procédé de détection d'un courant résiduel sur la base d'une commutation d'états de fonctionnement d'un noyau magnétique selon la revendication 1, dans lequel
un groupe de signaux de réponse d'excitation est généré en utilisant une tension positive et une tension négative, un traitement de données est réalisé en collectant des signaux de réponse positifs et négatifs dans une période d'excitation, et de multiples périodes d'excitation sont combinées pour déterminer le courant résiduel.

6. Procédé de détection d'un courant résiduel sur la base d'une commutation d'états de fonctionnement d'un noyau magnétique selon la revendication 1, dans lequel
la commutation entre trois modes de l'état de détection est commandée par la puce pour détecter un courant résiduel de forme d'onde complète, une valeur d'un signal correspondant au courant résiduel de forme d'onde complète est calculée au moyen d'un traitement algorithmique, et le signal est traité et une opération est réalisée sur la base du signal traité.

7. Procédé de détection d'un courant résiduel sur la base d'une commutation d'états de fonctionnement d'un noyau magnétique selon la revendication 1, dans lequel l'étape 4 comporte :
la réponse à des courants résiduels de formes d'ondes différentes avec une grande amplitude en cas d'un signal soudain, l'identification du signal soudain par le module algorithmique, et la commutation de l'état de détection par le module de commande d'état pour collecter et traiter le signal.

**Figure 1**

**Figure 2**

**Figure 3**

**Figure 4**

**Figure 5**

**Figure 6**

**Figure 7**

**EP 4 024 057 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3121609 A1